# EUROPEAN PATENT APPLICATION

(11) **EP 4 611 036 A1**
(43) Date of publication of application: **03.09.2025**
(21) Application number: 23890602.8
(22) Date of filing: 01.11.2023
(51) Int. Cl.: H01L 23/495, H01L 25/16, H01L 23/48, H01L 23/31, H01L 23/367

(54) **FRAME ASSEMBLY, POWER MODULE AND APPARATUS**

(30) Priority: 17.11.2022 CN 202211442178; 17.11.2022 CN 202211442179; 17.11.2022 CN 202211442180
(71) Applicant: Hisense Home Appliances Group Co., Ltd., Foshan, Guangdong 528303 (CN)
(72) Inventor: CHENG, Zhangming, Foshan, Guangdong 528303 (CN); LI, Zhengkai, Foshan, Guangdong 528303 (CN); XIE, Dilin, Foshan, Guangdong 528303 (CN); ZHOU, Wenjie, Foshan, Guangdong 528303 (CN); LIU, Jian, Foshan, Guangdong 528303 (CN); BIE, Qingfeng, Foshan, Guangdong 528303 (CN)
(74) Representative: Casalonga
(86) International application number: PCT/CN2023/128978
(87) International publication number: WO 2024/104166

(57) **Abstract**

A frame assembly, comprising a frame, and a plurality of pins, at least one substrate, at least one first connecting rod and at least one second connecting rod, which are located within the frame, wherein the frame comprises a first border and a third border, which are arranged opposite each other, and a second border, which is connected between the first border and the third border, one end of each pin among some of the plurality of pins is connected to the first border, and one end of each pin among the other pins is connected to the third border, the other end of each pin of at least one pin among a plurality of pins connected to the same border is connected to the substrate; one first connecting rod is connected between every two adjacent pins connected to the same border, and one second connecting rod is connected between each pin among a plurality of pins connected to the same border and the second border, the first connecting rod and the second connecting rod corresponding to each pin among the plurality of pins connected to the same border are arranged in a staggered manner in the extension direction of the second border, and with respect to the first connecting rod, the second connecting rod is closer to the substrate corresponding to the plurality of pins connected to the same border.

## Description

This application claims priority to Chinese Patent Application No. 202211442179.7, filed on November 17, 2022; Chinese Patent Application No. 202211442178.2, filed on November 17, 2022; and Chinese Patent Application No. 202211442180.X, filed on November 17, 2022, which are incorporated herein by reference in their entireties.

### TECHNICAL FIELD

The present disclosure relates to the technical field of electronic devices, and in particular to a frame assembly, a power module and a device.

### BACKGROUND

Power modules (PM) have characteristics of high current density, low saturation voltage, low driving power, high switching frequency, high functional integration level, convenience of use and good reliability. The power modules may be widely used in many fields such as consumer electronics, household appliances, automobiles, rail transit, industrial equipment, new and renewable sources of energy, smart grid, etc.

Generally, resin is used to package chips in the manufacturing process of power modules, so that the characteristic of a high integration level of the power module may be achieved. In this case, the power module product is also connected to a frame through connecting rods, and a cutting-rib forming process is also required to be carried out later. A flushing-cutting position of a cutter is positioned through a frame positioning holes on the frame, so as to complete the cutting-rib forming process of the product, and finally separate the product from the frame.

### SUMMARY

In an aspect, a frame assembly is provided. The frame assembly includes a frame, a plurality of pins, at least one substrate, at least one first connecting rod, and at least one second connecting rod that are located in the frame. The frame includes a first frame side and a third frame side that are disposed opposite to each other, and a second frame side connected between the first frame side and the third frame side. An end of a portion of the plurality of pins is connected to the first frame side, and an end of another portion of the plurality of pins is connected to the third frame side. Another end of at least one of the plurality of pins connected to a same frame side is connected to the substrate. The first connecting rod is connected between two adjacent pins of the plurality of pins connected to a same frame side. The second connecting rod is connected between the second frame side and the plurality of pins connected to a same frame side. The first connecting rod and the second connecting rod corresponding to the plurality of pins connected to a same frame side are disposed in a staggered manner in an extending direction of the second frame side; and in the extending direction of the second frame side, the second connecting rod is closer to the substrate corresponding to the plurality of pins connected to a same frame side than the first connecting rod.

In another aspect, a power module is provided. The power module includes a packaging body, a plurality of chips located in the packaging body, a plurality of pins, and at least one first insulating member located outside the packaging body. The plurality of chips include at least one driving chip and at least one power chip. The at least one driving chip and the at least one power chip are arranged at an interval in a width direction of the packaging body. The plurality of pins include a plurality of control pins led out from a second side of the packaging body and a plurality of power pins led out from a first side of the packaging body. The first side and the second side both extend in a length direction of the packaging body and are disposed opposite to each other. The plurality of control pins are arranged at intervals in the length direction of the packaging body and electrically connected to the at least one driving chip, and the plurality of power pins are arranged at intervals in the length direction of the packaging body and electrically connected to the at least one power chip. A first insulating member is connected between two adjacent control pins.

In yet another aspect, a device is provided. The device includes a controller and the power module provided in the embodiments described above. The power module is connected to the controller.

### BRIEF DESCRIPTION OF THE DRAWINGS

FIG. 1 is a schematic sectional view of a frame assembly in the related art;
FIG. 2 is a top view of a frame assembly after a bending-pin forming process is completed in the related art;
FIG. 3 is a side view of a frame assembly in a cutting process in the related art;
FIG. 4 is a sectional view of a frame assembly, in accordance with some embodiments;
FIG. 5 is a top view of a frame assembly after a bending-pin forming process is completed, in accordance with some embodiments;
FIG. 6 is a partial schematic diagram of the frame assembly in FIG. 5;
FIG. 7 is a partial schematic diagram of the frame assembly in FIG. 4;
FIG. 8 is a top view of a power module, in accordance with some embodiments;
FIG. 9 is a partial enlarged view of the region A of the power module in FIG. 8;
FIG. 10 is a schematic diagram of a frame assembly, in accordance with some embodiments;
FIG. 11 is a partial enlarged view of the region B of the frame assembly in FIG. 10;
FIG. 12 is a schematic sectional view of a power module taken along a width direction, in accordance with some embodiments;
FIG. 13 is a schematic sectional view of a power module taken along a width direction, in accordance with some embodiments;
FIG. 14 is a schematic sectional view of a power module taken along a width direction, in accordance with some embodiments;
FIG. 15 is a schematic sectional view of a power module taken along a width direction, in accordance with some embodiments;
FIG. 16 is a partial enlarged view of a power module, in accordance with some embodiments;
FIG. 17 is a sectional view of a power module, in accordance with some embodiments;
FIG. 18 is a partial enlarged view of the region C of the power module in FIG. 17;
FIG. 19 is a partial enlarged view of the region C of the power module in FIG. 17; and
FIG. 20 is a schematic diagram showing a structure of a device, in accordance with some embodiments.

### DETAILED DESCRIPTION

Some embodiments of the present disclosure will be described clearly and completely with reference to the accompanying drawings. However, the described embodiments are merely some but not all embodiments of the present disclosure. All other embodiments obtained by a person of ordinary skill in the art based on embodiments of the present disclosure shall be included in the protection scope of the present disclosure.

Unless the context requires otherwise, throughout the description and the claims, the term "comprise" and other forms thereof such as the third-person singular form "comprises" and the present participle form "comprising" are construed as an open and inclusive meaning, i.e., "including, but not limited to". In the description of the specification, the terms such as "one embodiment", "some embodiments", "exemplary embodiments", "example", "specific example", or "some examples" are intended to indicate that specific features, structures, materials, or characteristics related to the embodiment(s) or example(s) are included in at least one embodiment or example of the present disclosure. Schematic representations of the above terms do not necessarily refer to the same embodiment(s) or example(s). In addition, the specific features, structures, materials, or characteristics may be included in any one or more embodiments or examples in any suitable manner.

Hereinafter, the terms "first" and "second" are used for descriptive purposes only, and are not to be construed as indicating or implying a relative importance or implicitly indicating the number of indicated technical features. Thus, a feature defined with "first" or "second" may explicitly or implicitly include one or more of the features. As used in this description and the appended claims, the singular forms "a/an," and "the" also include plural referents unless the content clearly dictates otherwise. In the description of the embodiments of the present disclosure, the term "a/the plurality of" means two or more unless otherwise specified.

In the description of some embodiments, the expression "connected", and derivative thereof may be used. For example, the term "connected" may be used in the description of some embodiments to indicate that two or more components are in direct physical or electrical contact with each other. The embodiments disclosed herein are not necessarily limited to the content herein.

The phrase "at least one of A, B, and C" has the same meaning as the phrase "at least one of A, B, or C", both including the following combinations of A, B, and C: only A, only B, only C, a combination of A and B, a combination of A and C, a combination of B and C, and a combination of A, B, and C.

The phrase "A and/or B" includes following three combinations: only A, only B, and a combination of A and B.

The term "about", "substantially", and "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

Exemplary embodiments are described herein with reference to sectional views and/or plan views as idealized exemplary drawings. In the accompanying drawings, thicknesses of layers and regions are enlarged for clarity. The exemplary embodiments of the present disclosure should not be construed as being limited to the shapes of the regions shown herein, but including shape deviations due to, for example, manufacturing. For example, an etched region shown to have a rectangular shape generally has a curved feature. Therefore, the regions shown in the accompanying drawings are schematic in nature, and their shapes are not intended to show actual shapes of the regions in devices, and are not intended to limit the scope of the exemplary embodiments.

In a cutting-rib forming process for manufacturing a power module, the power module is connected to a frame, and a flushing-cutting position of a cutter is positioned through frame positioning holes on the frame, so as to complete the cutting-rib forming process of the final product. After connecting rods between pins are cut off to separate and form the pins, the product is connected to the frame by only a single connecting rod, and the connecting rod at this position is cut off when the product is separated, so that the separation between the product and the frame is completed.

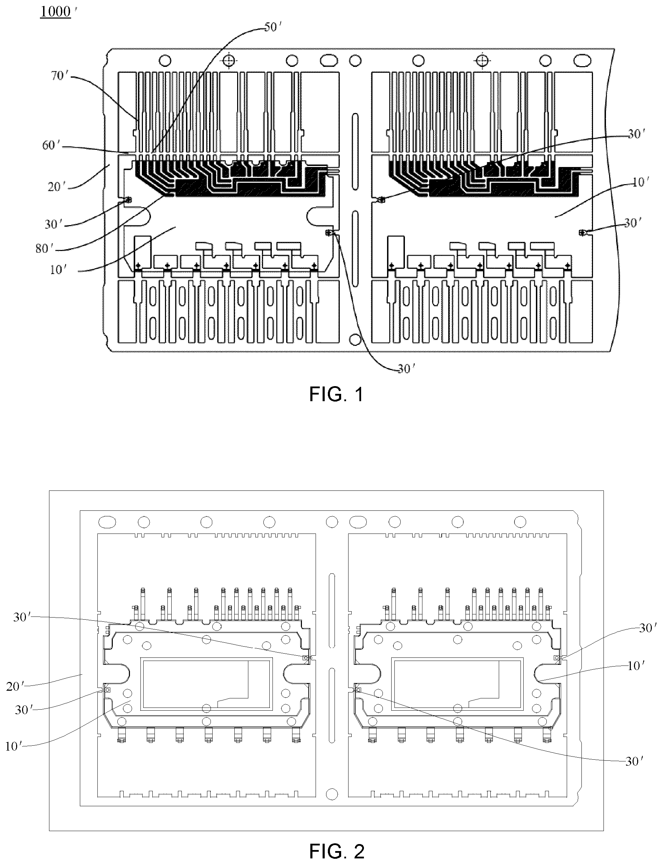

As shown in FIGS. 1 to 3, in the frame assembly 1000' in the related art, a first connecting rod 30' is connected between a power module 10' and an outer frame 20', and the first connecting rod 30' extends into the inside of the power module 10', but not be connected to any pin in the power module 10'. That is to say, the first connecting rod 30' may be considered as a pin without connection, which only serves to connect the power module 10' and the outer frame 20'.

In a process of separating the power module 10' from the outer frame 20', the first connecting rod 30' is generally cut off from the power module 10' to the greatest extent, so as to ensure the performance and process requirements of the power module 10'. In a process of cutting off the first connecting rod 30', a flushing-cutting cutter 40' is required to be used to cut off the first connecting rod 30'. During the cutting, it is possible to cause the resin colloid around the first connecting rod 30' to break or crack due to the flushing-cutting force of the flushing-cutting cutter 40'.

In addition, in the frame assembly 1000' in the related technology, the pin 70' is connected between the substrate 80' and the outer frame 20', and a second connecting rod 50' is disposed between two adjacent pins 70'. A third connecting rod 60' is also disposed between the outer frame 30' and the pin 70', and the second connecting rod 50' and the third connecting rod 60' are located in a same straight line. Generally, the bending-pin forming process is also required to be carried out when the power module 10' is separated from the outer frame 20'. Since the second connecting rod 50' and the third connecting rod 60' are located in a straight line, the third connecting rod 60' may interfere with the forming of bent pins when the bending-pin forming process is performed on the pins, thereby affecting the production of the product.

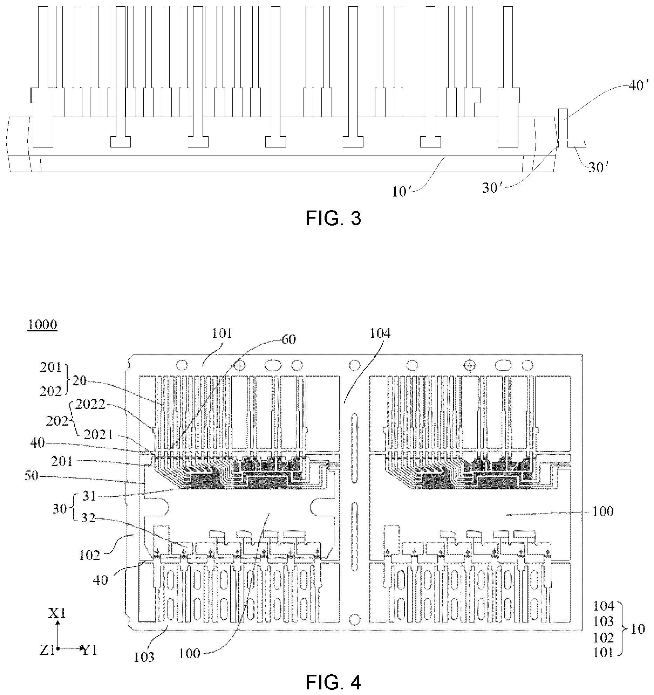

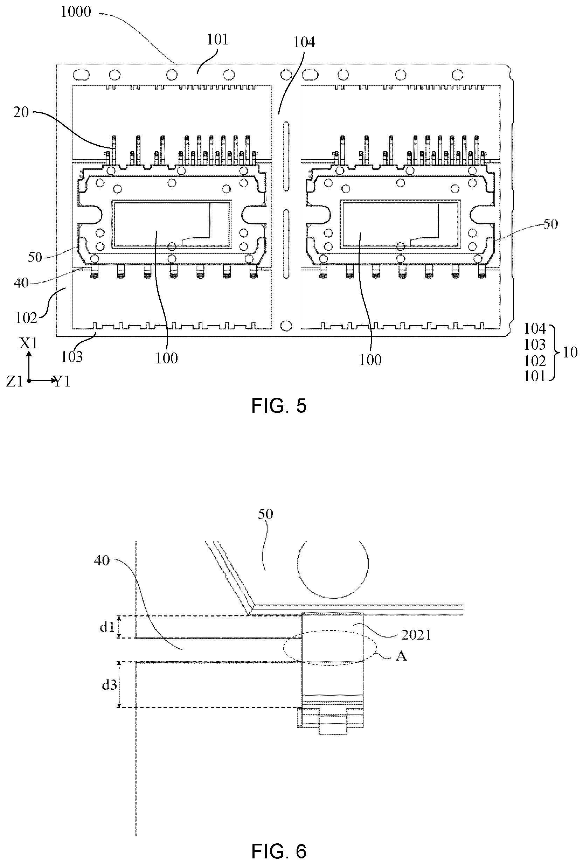

On this basis, a frame assembly is provided in embodiments of the present disclosure. As shown in FIGS. 4 and 5, the frame assembly 1000 includes a frame 10 and a power module 100 located in the frame 10 and connected to the frame 10. The power module 100 includes a plurality of pins 20 and at least one substrate 30.

The frame 10 includes a first frame side 101, a third frame side 103, and a second frame side 102 connected between the first frame side 101 and the third frame side 103. For example, the first frame side 101 and the third frame side 103 are disposed opposite to each other, and the second frame side 102 is connected to end portions of the first frame side 101 and the third frame side 103 located on a same side.

As shown in FIG. 4, in the plurality of pins 20, ends of some pins 20 are connected to the first frame side 101, and ends of other pins 20 are connected to the third frame side 103. Another end of at least one of the plurality of pins 20 connected to a same frame side is connected to a substrate 30. In this way, the substrate 30 may be electrically connected to external devices through the pins 20 connected thereto, so as to ensure the structural reliability of the substrate 30.

As shown in FIG. 4, the frame assembly 1000 further includes a first connecting rod 60 located in the frame 10. The first connecting rod 60 is connected between two adjacent pins 20 in the plurality of pins 20 connected to a same frame side.

For example, the first connecting rod 60 may be connected between two adjacent pins 20 in the plurality of pins 20 connected to the first frame side 101. For another example, the first connecting rod 60 may be connected between two adjacent pins 20 in the plurality of pins 20 connected to the third frame side 103.

For example, a first connecting rod 60 is connected between every two adjacent pins 20 in the plurality of pins 20 connected to a same frame side, and a plurality of first connecting rods 60 may be located in a same straight line.

As shown in FIG. 4, the frame assembly 1000 further includes a second connecting rod 40 located in the frame 10. The second connecting rod 40 is connected between the second frame side 102 of the frame 10 and the plurality of pins 20 connected to a same frame side. The second connecting rod 40 is used to fix the power module 100 with the frame 10, so that the power module 100 may be stably connected in the frame assembly 1000.

For example, a second connecting rod 40 may be connected between the second frame side 102 of the frame 10 and the plurality of pins 20 connected to the first frame side 101. For another example, a second connecting rod 40 may be connected between the second frame side 102 of the frame 10 and the plurality of pins 20 connected to the third frame side 103.

In this way, not only the stability and reliability of the power module 100 disposed on the frame assembly 1000 may be improved, and the problem of material jamming and deformation during the cutting-rib forming transport process may be avoided; but also there is no need to separately provide an additional connecting rod to connect the frame 10 and the power module 100, and the power module 100 may be separated from the frame assembly 1000 only by cutting off the second connecting rod 40 in the subsequent process of separating the power module 100 from the frame assembly 1000. Moreover, there is no connection between the second connecting rod 40 and a packaging body 50 (as shown in FIGS. 4 and 5) of the power module 100 for packaging a main structure of the power module 100, and the second connecting rod 40 may not extend into the inside of the power module 100. Therefore, when the second connecting rod 40 is cut off, it is possible to prevent the packaging body of the power module 100 from being damaged or cracked, and ensure the structural stability of the power module 100.

In the frame assembly 1000 provided in the embodiments of the present disclosure, as shown in FIG. 4, the first connecting rod 60 and the second connecting rod 40 corresponding to the plurality of pins 20 connected to a same frame side are disposed in a staggered manner in an extending direction of the second frame side 102. Moreover, in the extending direction of the second frame side 102, the second connecting rod 40 is closer to the substrate 30 corresponding to the plurality of pins 20 connected to a same frame side than the first connecting rod 60.

Here, it will be noted that the "first connecting rod 60 corresponding to the plurality of pins 20 connected to a same frame side" refers to the first connecting rod 60 connected between the plurality of pins 20 connected to a same frame side; the "second connecting rod 40 corresponding to the plurality of pins 20 connected to a same frame side" refers to the second connecting rod 40 connected between the second frame side 102 of the frame 10 and the plurality of pins 20 connected to a same frame side; and the "substrate 30 corresponding to the plurality of pins 20 connected to a same frame side" refers to the substrate 30 connected to at least one pin 20 of the plurality of pins 20 connected to a same frame side.

For example, as shown in FIG. 4, for the plurality of pins 20 connected to the first frame side 101 of the frame 10, at least one pin 20 is connected to the substrate 31, a first connecting rod 60 is connected between two adjacent pins 20, and a second connecting rod 40 is connected between the second frame side 102 of the frame 10 and the plurality of pins 20 connected to the first frame side 101 of the frame 10. In this case, in the extending direction X1 of the second frame side, the first connecting rod 60 and the second connecting rod 40 are disposed in a staggered manner, and the second connecting rod 40 is closer to the substrate 31 than the first connecting rod 60.

It will be noted that, as shown in FIG. 4, each pin 20 extends substantially along the extending direction X1 of the second frame side as a whole before being separated and formed.

A bending-pin forming process is required to be performed on the pins 20 after the pins 20 are separated and formed by cutting off the first connecting rods 60. That is to say, the pins 20 are bent in a thickness direction Z1 of the frame 10. The pins 20 after the bending-pin forming process are shown in FIG. 5. Generally, each pin 20 is bent near a position of the pin 20 where a portion of the first connecting rod 60 away from the substrate 30 is located.

In the frame assembly 1000 provided in the embodiments of the present disclosure, in the extending direction X1 of the second frame side, the first connecting rod 60 and the second connecting rod 40 are disposed in a staggered manner, and the second connecting rod 40 is closer to the substrate 30 than the first connecting rod 60. In this way, during the bending-pin forming process, since the second connecting rod 40 is far away from a bending position of the pin 20, it is possible to effectively prevent the second connecting rod 40 from interfering with the forming of bent pins.

Here, the thickness direction Z1 of the frame refers to a direction perpendicular to a plane where the frame 10 is located. The plane where the frame 10 is located is a plane formed by the first frame side 101, the second frame side 102 and the third frame side 103 of the frame 10.

In some embodiments, the plurality of pins 20 connected to a same frame side are arranged at intervals in the extending direction of the frame side, and the second connecting rod 40 is connected between a pin 20 closest to the second frame side 102 in the plurality of pins 20 and the second frame side 102.

For example, as shown in FIG. 4, the plurality of pins 20 connected to the first frame side 101 are arranged at intervals in an extending direction Y1 of the first frame side 101, and the second connecting rod 40 is connected between a pin 20 closest to the second frame side 102 in the plurality of pins 20 and the second frame side 102.

In this way, not only the installation stability and reliability of the plurality of pins 20 may be ensured, but also the plurality of pins 20 may be prevented from contacting each other and causing failures. Moreover, the second connecting rod 40 may also be stably and firmly connected to the pins 20 and the frame 10 without affecting the interval arrangement of the plurality of pins 20, so that the power module 100 may be stably and firmly connected with the frame 10, and the problem of material jamming during the cutting-rib forming transport process of the frame assembly 1000 may be avoided.

In some examples, as shown in FIG. 4, the frame assembly 1000 includes a plurality of substrates 30, such as a driving substrate 31 and a power substrate 32. The driving substrate 31 and the power substrate 32 are arranged at an interval in the extending direction X1 of the second frame side 102 of the frame 10. At least one pin 20 in the plurality of pins 20 connected to the first frame side 101 may be connected to the driving substrate 31. In this case, the plurality of pins 20 may also be referred to as driving pins, and the driving substrate 31 is electrically connected to external devices through the driving pins connected thereto, so as to achieve the function of the driving substrate 31. At least one pin 20 in the plurality of pins 20 connected to the third frame side 103 may be connected to the power substrate 32. In this case, the plurality of pins 20 may also be referred to as power pins, and the power substrate 32 is electrically connected to external devices through the power pins connected thereto, so as to achieve the function of the power substrate 32.

On this basis, the frame assembly 1000 includes a plurality of second connecting rods 40. A second connecting rod 40 is connected between the second frame side 102 and a pin 20 closest to the second frame side 102, and the pin 20 is a pin of the plurality of pins 20 that are connected to the first frame side 101 and arranged at intervals in the extending direction of the first frame side 101. Another second connecting rod 40 may be connected between the second frame side 102 and a pin 20 closest to the second frame side 102, and the pin 20 is a pin of the plurality of pins 20 that are connected to the third frame side 103 and arranged at intervals in the extending direction of the third frame side 103.

It will be noted that, in the frame assembly 1000 provided in some embodiments of the present disclosure, the first frame side 101 and the third frame side 103 of the frame 10 are disposed opposite to each other, and the extending directions of the two may be same. For example, the extending directions of the first frame side 101 and the third frame side 103 are both indicated by Y1 in FIG. 4.

In this way, two sides of the power module 100 in its length direction (e.g., the same direction as the extending direction X1 of the second frame side 102 of the frame) are both connected to the frame 10, so that the power module 100 is subjected to even force on two sides of the power module 100 in its length direction. As a result, it is possible to further improve the stability and firmness of the connection of the power module 100 on the frame assembly 1000, and avoid the material jamming and deformation of the power module 100 during the cutting-rib forming transport process.

In some embodiments, as shown in FIGS. 4 and 5, the frame 10 further includes a fourth frame side 104 disposed opposite to the second frame side 102 and connected between the first frame side 101 and the third frame side 103. In this case, the plurality of pins 20 connected to a same frame side are arranged at intervals in the extending direction of the frame side. Moreover, a second connecting rod 40 is connected between a pin 20 closest to the second frame side 102 in the plurality of pins 20 and the second frame side 102, and a second connecting rod 40 is also connected between a pin 20 closest to the fourth frame side 104 in the plurality of pins 20 and the fourth frame side 104.

For example, the plurality of pins 20 connected to the first frame side 101 are arranged at intervals in the extending direction of the first frame side 101. Moreover, a second connecting rod 40 is connected between a pin 20 closest to the second frame side 102 in the plurality of pins 20 and the second frame side 102, and a second connecting rod 40 is also connected between a pin 20 closest to the fourth frame side 104 in the plurality of pins 20 and the fourth frame side 104.

For another example, the plurality of pins 20 connected to the third frame side 103 are arranged at intervals in the extending direction of the third frame side 103. Moreover, a second connecting rod 40 is connected between a pin 20 closest to the second frame side 102 in the plurality of pins 20 and the second frame side 102, and a second connecting rod 40 is also connected between a pin 20 closest to the fourth frame side 104 in the plurality of pins 20 and the fourth frame side 104.

In this way, not only the power module 100 may be subjected to even force in the frame assembly 1000, but the installation stability and reliability of the power module 100 in the frame assembly 1000 may also be further improved.

In the frame assembly 1000 provided in some embodiments of the present disclosure, as shown in FIGS. 4 and 5, the power module 100 connected to the frame 10 further includes a packaging body 50 for packaging a main structure of the power module 100, such as a power substrate and a power chip connected to the power substrate, a driving substrate and a driving chip connected to the driving substrate, so that the characteristic of a high integration level of the power module 100 may be achieved and the insulation and electrical safety of the power module 100 may be ensured.

On this basis, as shown in FIG. 4, the pin 20 includes a first portion 201 located in the packaging body 50 and a second portion 202 led out of the packaging body 50. The first portion 201 of the pin 20 located in the packaging body 50 is connected to the substrate 30 (e.g., the driving substrate 31 or the power substrate 32), so that the stability and reliability of the electrical connection between the first portion 201 and the substrate 30 may be ensured.

For the pin 20 connected to the second connecting rod 40, the second connecting rod 40 is connected to the second portion 202 of the pin 20. Since the second portion 202 is located outside the packaging body 50, the second connecting rod 40 may not be affected by the packaging of the packaging body 50, so that the stability and independence of the arrangement of the second connecting rod 40 may be ensured. In the subsequent flushing-cutting process of the second connecting rod 40, the flushing-cutting force may not affect the packaging body 50 of the power module 100 and cause damage or cracks to the packaging body 50, so that the stability and reliability of the power module 100 in the frame assembly 1000 may be ensured, thereby ensuring the structural stability of the power module 100 after being separated from the frame assembly 1000.

In some embodiments, the second portion 202 of the pin 20 may include a first sub-segment 2021 and a second sub-segment 2022, and the first sub-segment 2021 is connected between the first portion 201 of the pin 20 and the second sub-segment 2022. When the bending-pin forming process is performed on the pins, the second sub-segment 2022 may be bent in the thickness direction Z1 of the frame with respect to the first sub-segment 2021. In this case, the second connecting rod 40 is connected to the first sub-segment 2021 of the second portion 202 of the pin 20. In this way, it is possible to prevent the second connecting rod 40 from interfering with the bending-pin forming process.

In some embodiments of the present disclosure, the second connecting rod 40 is connected to the first sub-segment 2021 of the second portion 202 of the pin 20, so that the second sub-segment 2022 of the pin may be bent in the thickness direction Z1 of the frame with respect to the first sub-segment 2021 during the bending-pin forming process. Therefore, a distance from a connection between the second connecting rod 40 and the first sub-segment 2021 of the second portion 202 of the pin 20 to the packaging body 50 and a distance from the connection between the second connecting rod 40 and the first sub-segment 2021 of the second portion 202 of the pin 20 to the second sub-segment 2022 of the second portion 202 of the pin both affect the bending of the pin 20.

In some embodiments, as shown in FIG. 6, a minimum distance d1 from a connection A between the second connecting rod 40 and the first sub-segment 2021 of the second portion 202 of the pin 20 to the packaging body 50 is greater than a thickness of the frame 10. In this way, the minimum distance from the connection A between the first sub-segment 2021 and the second connecting rod 40 to the packaging body 50 may be set reasonably, which may further prevent the second connecting rod 40 from interfering with the bending-pin forming process.

Here, the thickness of the frame 10 refers to a dimension of the frame 10 in the thickness direction Z1 thereof.

In some embodiments, as shown in FIG. 6, a minimum distance d3 from the connection A between the second connecting rod 40 and the first sub-segment 2021 of the second portion of the pin to the second sub-segment 2022 of the second portion 202 of the pin is greater than the thickness of the frame 10. In this way, the minimum distance from the connection A between the second connecting rod 40 and the first sub-segment 2021 to the second sub-segment 2022 of the pin may be set reasonably, which may further prevent the second connecting rod 40 from interfering with the bending-pin forming process.

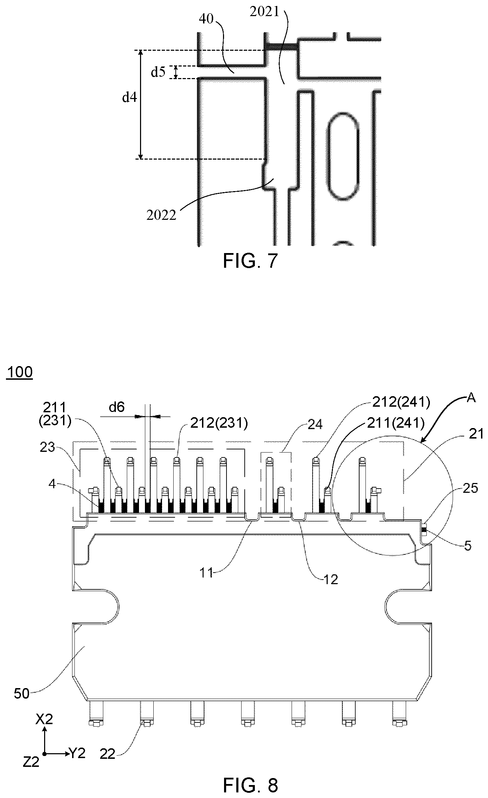

In some embodiments, as shown in FIG. 7, a length d4 of the first sub-segment 2021 is greater than a width d5 of the second connecting rod 40. The length of the first sub-segment 2021 refers to a dimension of the first sub-segment 2021 in the extending direction (i.e., the extending direction X1 of the second frame side) of the pin, and the width of the second connecting rod 40 refers to a dimension of the second connecting rod 40 in the extending direction X1 of the second frame side.

The first sub-segment 2021 extends in the extending direction of the pin itself, the extending direction of the pin itself is substantially the same as the extending direction of the second frame side 102, and the second connecting rod 40 is connected between the pin and the second frame side 102. Therefore, it may be understood that there is an included angle between the extending direction of the first sub-segment 2021 and the extending direction of the second connecting rod 40. The length d4 of the first sub-segment 2021 is greater than the width d5 of the second connecting rod 40, which may be conducive to the connection between the second connecting rod 40 and the first sub-segment 2021 and further prevent the second connecting rod 40 from interfering with the bending-pin forming process.

In some embodiments, the second connecting rod 40 may be vertically connected to the first sub-segment 2021. That is to say, the extending direction of the second connecting rod 40 may be perpendicular to the extending direction of the first sub-segment 2021.

In the frame assembly 1000 provided in some embodiments of the present disclosure, as shown in FIGS. 4 to 7, the second connecting rod 40 may extend in the extending direction of the first frame side 101 or the third frame side 103 of the frame 10, and the extending direction of the first sub-segment 2021 may be the same as the extending direction of the second frame side 102 of the frame 10. For example, the extending direction of the first frame side 101 or the third frame side 103 may be perpendicular to the extending direction of the second frame side 102.

In this way, the connection between the second connecting rod 40 and the first sub-segment 2021 may be stable and firm, so that the stability of the connection between the second connecting rod 40 and the power module 100 may be improved.

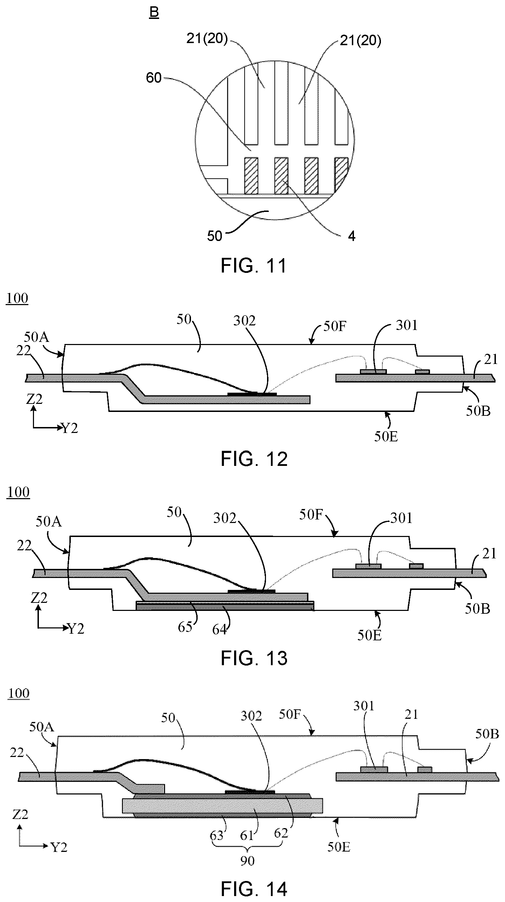

A power module 100 is provided in some embodiments of the present disclosure. As shown in FIGS. 12 to 15, a main structure of the power module 100 includes a plurality of chips 300 and a plurality of pins 20. The plurality of chips 300 include at least one driving chip 301 and at least one power chip 302, and the plurality of pins 20 include a plurality of control pins 21 electrically connected to the driving chip 301 and a plurality of power pins 22 electrically connected to the power chip 302. The power pins 22 are used to connect the power chip 302 with external driving components, and the control pins 21 are used to connect the driving chip 301 with external controllers. The power chip 302 is also electrically connected to the driving chip 301, and the driving chip 301 is used to drive the power chip 302.

As shown in FIGS. 4, 5, 8, 10 and 12 to 15, the power module 100 further includes a packaging body 50 for packaging the main structure. The packaging body 50 has a first side 50A and a second side 50B that are disposed opposite to each other and extend in the length direction Y2 of the packaging body. For example, an extending direction of the first side 50A may be the same as an extending direction of the second side 50B.

The plurality of control pins 21 are led out from the second side 50B of the packaging body 50 and arranged at intervals in the extending direction of the second side 50B. The power pins 22 are led out from the first side 50A of the packaging body 50 and arranged at intervals in the extending direction of the first side 50A. The packaging body 50 packages the plurality of chips 300 together, so as to achieve high integration of the power module 100 and ensure insulation and electrical safety of the power module 100.

The driving chip 301 and the power chip 302 are arranged at an interval in the width direction of the packaging body 50. Here, a direction from the first side 50A to the second side 50B of the packaging body is referred to as a width direction X2 of the packaging body, and a direction in which the plurality of control pins 21 or the plurality of power pins 22 are arranged is referred to as a length direction Y2 of the packaging body.

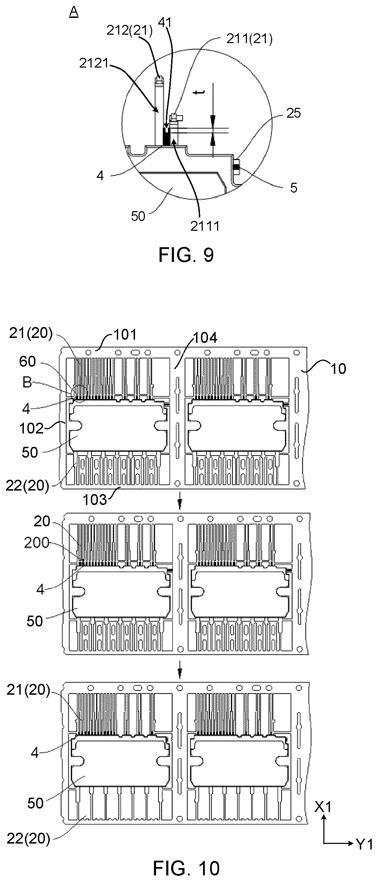

It will be noted that in the embodiments of the present disclosure, in a case where the power module 100 is still located in the frame assembly 1000, that is, the power module has not yet been separated from the frame 10 of the frame assembly 1000, as shown in FIGS. 4 and 10, the plurality of control pins 21 included by the power module 100 are connected to the first frame side 101 of the frame 10, and the power pins 22 included by the power module 100 are connected to the third frame side 103 of the frame 10. For example, the extending direction Y1 of the first frame side 101 or the third frame side 103 may be the same as the length direction Y2 of the packaging body, and the extending direction X1 of the second frame side may be the same as the width direction X2 of the packaging body.

At present, due to the trend of high density, high integration, and miniaturization of the semiconductor device (e.g., the power module), the pins of semiconductor device (e.g., the power module) have a gradually increasing trend, and the width of the pin and the distance between the pins have also tended to narrow. The width of the pin and the distance between the pins both affect the structural strength of the pins, thereby affecting the insulation between the pins.

On this basis, as shown in FIGS. 8 to 11, the power module 100 provided in some embodiments of the present disclosure further includes at least one first insulating member 4 located outside the packaging body 50. Two adjacent control pins 21 in the plurality of control pins 21 are a first control pin 211 and a second control pin 212, respectively. A first insulating member 4 is connected between the first control pin 211 and the second control pin 212. The first insulating member 4 is used to support the two adjacent control pins 21 (i.e., the first control pin 211 and the second control pin 212), so as to prevent a distance between the first control pin 211 and the second control pin 212 from being shortened due to the deformation of the first control pin 211 and the second control pin 212, so that the insulation between the two adjacent control pins 21 may be ensured.

As shown in FIG. 8, in some embodiments, the power module 100 includes nineteen control pins 21, ten control pins 21 of the nineteen control pins 21 are first control pins 211 and nine control pins 21 of the nineteen control pins 21 are second control pins 212. The ten first control pins 211 and the nine second control pins 212 are arranged alternately in the length direction Y2 of the packaging body 50. The first insulating member 4 is connected between adjacent first control pin 211 and second control pin 212 that are proximate to each other.

As shown in FIG. 10, before the packaging body 50 packages the plurality of chips and the plurality of pins have not yet been separated and formed (that is, the pins 20 are still connected to the frame 10 of the frame assembly 1000), the plurality of pins are connected through the first connecting rod 60, and the first insulating member 4 is connected between two adjacent control pins 21 (i.e., the first control pin and the second control pin) and located on a side of the first connecting rod 60 proximate to the packaging body 50. Afterwards, a cutter 200 is usually used to cut off the first connecting rod 60 between two adjacent control pins 21 during the cutting-rib forming process, so as to disconnect the connection between the two adjacent control pins 21, and separate and form the control pins 21, so that the electrical performance of the control pins 21 may be achieved. In this case, the first insulating member 4 is filled in a gap between the first control pin 211 and the second control pin 212, so as to effectively separate the first control pin 211 from the second control pin 212, and effectively support the first control pin 211 and the second control pin 212, which prevents the distance between the first control pin 211 and the second control pin 212 from being shortened due to the deformation of the first control pin 211 and the second control pin 212. As a result, the insulation distance between the first control pin 211 and the second control pin 212 may be ensured, and the insulation between the two control pins 21 may be further ensured.

In some embodiments, as shown in FIGS. 9 and 11, the first insulating member 4 is connected to a portion of the packaging body 50 located between two adjacent control pins 21. That is to say, an end of the first insulating member 4 in the length direction of the pin is connected to the packaging body 50, so as to ensure the connection reliability of the first insulating member 4 and prevent the first insulating member 4 from falling off after the power module 100 is used for a long time.

Here, the length direction of the pin may be substantially the same as the width direction of the packaging body.

In some embodiments, as shown in FIGS. 8 and 9, in the width direction X2 of the packaging body 50, a length of the first insulating member 4 is less than a length of at least one of the two adjacent control pins 21 connected with the first insulating member 4.

Here, the length of the first insulating member 4 refers to a dimension of the first insulating member 4 in the width direction X2 of the packaging body 50, and the length of the control pin 21 refers to a dimension of the control pin 21 in the width direction X2 of the packaging body 50.

For example, in the width direction X2 of the packaging body 50, the length of the first insulating member 4 is less than the length of the first control pin 211. For another example, in the width direction X2 of the packaging body 50, the length of the first insulating member 4 is less than the length of the second control pin 212.

In some embodiments of the present disclosure, a bending-pin forming process is also required to be performed on the pins 20 after the first connecting rod 60 is cut off to separate and form the pins 20 (including the control pin 21 and the power pin 22). That is to say, each pin 20 is bent in the thickness direction Z1 of the frame 10. The pins 20 after the bending-pin forming process are shown in FIGS. 5 and 8. After the bending-pin forming process, as shown in FIG. 9, the first control pin 211 includes a first portion 2111 and a second portion (not shown in the drawing) connected to each other, and the second portion is bent with respect to the first portion 2111. The first portion 2111 extends in the width direction X2 of the packaging body 50, and the second portion extends in the thickness direction Z2 of the packaging body 50. It may be seen from above description that the width direction X2 of the packaging body 50 is substantially perpendicular to the thickness direction Z2 of the packaging body 50. In this case, the first portion 2111 of the first control pin 211 is substantially perpendicular to the second portion. That is to say, a shape of the first control pin 211 is substantially in a shape of a capital letter "L". Similarly, the second control pin 212 includes a first portion 2121 and a second portion (not shown in the drawing) connected to each other. The first portion 2121 extends in the width direction X2 of the packaging body 50, and the second portion extends in the thickness direction Z2 of the packaging body 50. That is to say, in this case, the second control pin 212 is substantially in a shape of a capital letter "L".

It will be noted that, as shown in FIGS. 12 to 15, the packaging body 50 further includes a bottom surface 50E and a top surface 50F that are connected to the first side 50A, the second side 50B, the third side 50C and the fourth side 50D. In the embodiments of the present disclosure, a direction from the bottom surface 50E to the top surface 50F is referred to as the thickness direction Z2. It will also be noted that, as shown in FIGS. 4, 5 and 10, since the power module 100 is connected in the frame 10, the thickness direction Z2 of the packaging body herein may be understood to be the same as the thickness direction Z1 of the frame.

In this case, in the width direction X2 of the packaging body 50, the length of the first insulating member 4 is less than a length of the first portion 2111 of the first control pin 211 and/or a length of the first portion 2121 of the second control pin 212. In this way, it may be ensured that the first insulating member 4 may effectively support between the first portion 2111 of the first control pin 211 and the first portion 2121 of the second control pin 212, so as to prevent the first insulating member 4 from interfering with other components outside the power module 100 when the power module 100 is installed, due to a free end (i.e., an end away from the packaging body 50) of the first insulating member 4 protruding beyond the first control pin 211 and the second control pin 212 in the width direction X2 of the packaging body 50.

In the power module 100 provided in some embodiments of the present disclosure, as shown in FIG. 8, a minimum distance d6 between the first control pin 211 and the second control pin 212 may be less than or equal to 0.5 mm. Therefore, a lot of first control pins 211 and second control pins 212 may be disposed within a limited range; alternatively, in a case where the number of first control pins 211 and the number of second control pins 212 are constant, a dimension of the power module 100 in its width direction may be reduced, so that the miniaturization of the power module 100 may be improved. The minimum distance between the first control pin 211 and the second control pin 212 is the minimum distance to ensure insulation between the first control pin 211 and the second control pin 212. That is to say, the minimum distance d6 is a creepage distance between the first control pin 211 and the second control pin 212.

In some embodiments, as shown in FIGS. 8 and 9, the first insulating member 4 is connected between opposite sides (i.e., the side 211A of the first control pin 211 and the side 212A of the second control pin 212 in FIG. 8) of two adjacent control pins 21. That is to say, in the length direction Y2 of the packaging body, two opposite sides of the first insulating member 4 are connected to the side 211A of the first control pin 211 and the side 212A of the second control pin 212, respectively. Therefore, the bonding forces between the first insulating member 4 and the first control pin 211 and between the first insulating member 4 and the second control pin 212 may be strengthened, and the first control pin 211 and the second control pin 212 may be prevented from being deformed in the thickness direction Z2 of the packaging body 50.

In some embodiments, the first insulating member 4 is connected between opposite surfaces of two adjacent control pins 21 (i.e., the first control pin 211 and the second control pin 212); moreover, in the thickness direction Z2 of the packaging body 50, two opposite surfaces of the first insulating member 4 are flush with two opposite surfaces of the first control pin 211, respectively, and the two opposite surfaces of the first insulating member 4 are also flush with two opposite surfaces of the second control pin 212, respectively. In this way, a surface of the first control pin 211 in the thickness direction Z2 of the packaging body 50 and a surface of the second control pin 212 in the thickness direction Z2 of the packaging body 50 may be located in a same plane, and another surface of the first control pin 211 in the thickness direction Z2 of the packaging body 50 and another surface of the second control pin 212 in the thickness direction Z2 of the packaging body 50 are located in a same plane, so that the coplanarity between the first control pin 211 and the second control pin 212 may be ensured. The coplanarity is also referred to as flatness, which may reflect the coplanar condition of the plurality of pins. When the plurality of pins are fabricated, surfaces of the plurality of pins are not absolutely even. The coplanarity is a difference between an unevenness surface and an absolute horizontal plane, and the smaller the difference, the better the coplanarity.

In some embodiments, a cutting portion 41 is disposed at an end of the first insulating member 4 away from the packaging body 50. For example, a cutting portion 41 is disposed at an end (i.e., the free end) of the first insulating member 4 in the length direction of the pin, and the end of the first insulating member 4 is not connected to the packaging body.

As shown in FIG. 10, in the process of cutting off the first connecting rod 60 between adjacent pins, the cutter 200 covers the entire first connecting rod 60 in the width direction X2 of the packaging body 50, and may also cover a portion of the end of the first insulating member 4 away from the packaging body 50 in consideration of tolerance, thereby ensuring that the first connecting rod 60 may be completely cut off. In this case, the portion of the end of the first insulating member 4 away from the packaging body 50 that is covered by the cutter 200 is cut off to form the cutting portion 41.

For example, as shown in FIG. 9, the cutting portion 41 may be a through groove. That is to say, the cutting portion 41 penetrates through two surfaces of the first insulating member 4 in the thickness direction Z2 of the packaging body. In this way, it may be further ensured that the first connecting rod 60 between adjacent pins is completely cut off, thereby ensuring the insulation of two adjacent pins.

In some examples, as shown in FIG. 9, a distance t between a bottom wall of the cutting portion 41 and a surface of the end of the first insulating member 4 away from the packaging body 50 may be greater than or equal to 0.1 mm, which may effectively ensure that the cutter 200 may completely cut off the first connecting rod 60, so as to ensure that the first control pin 211 and the second control pin 212 are insulated from each other.

In some embodiments, as shown in FIGS. 8 and 9, the plurality of pins 20 further include two supporting pins 25 led out from the third side 50C of the packaging body and arranged at an interval. The third side 50C is adjacent to the second side 50B and extends in the width direction X2 of the packaging body 50. The supporting pins 25 are used to cooperate with the control pins 21 to support the power module 100 from different directions, so as to improve the stability of the power module 100 and prevent the power module 100 from being deformed. In this case, the power module further includes a second insulating member 5 connected between the two supporting pins 25. The second insulating member 5 is located outside the packaging body 50 and used to support the two supporting pins 25, so as to prevent the two supporting pins 25 from being deformed, and ensure insulation between the two supporting pins 25.

In some embodiments, the second insulating member 5 is connected to a portion of the packaging body 50 located between the two supporting pins 25. That is to say, an end of the second insulating member 5 in a length direction of the supporting pin 25 is connected to the packaging body 50, which may improve the connection reliability of the second insulating member 5 and prevent the second insulating member 5 from falling off after the power module 100 is used for a long time.

Here, the length direction of the supporting pin 25 refers to a length direction of a portion of the supporting pin 25 led out of the packaging body 50. Since the supporting pins 25 are led out from the third side 50C of the packaging body, the length direction of the portion of the supporting pin 25 led out of the packaging body 50 may be substantially the same as the length direction of the packaging body.

In some examples, an end surface of another end of the second insulating member 5 in the length direction of the supporting pin 25 may be flush with end surfaces of free ends (i.e., end portions of the portions of the supporting pins 25 led out of the packaging body 50) of the supporting pins 25, which may ensure the regularity of the appearance of the power module 100 and prevent the second insulating member 5 from interfering with other components outside the power module 100.

In some examples, as shown in FIGS. 8 and 9, in the width direction X2 of the packaging body, opposite sides of the second insulating member 5 are connected to opposite sides of the two supporting pins 25, respectively. Therefore, the bonding force between the second insulating member 5 and the two supporting pins 25 may be strengthened, and the two supporting pins 25 may be prevented from being deformed in the thickness direction of the packaging body 50.

In some examples, in the thickness direction Z2 of the packaging body 50, two opposite surfaces of the second insulating member 5 are flush with two opposite surfaces of any of two supporting pins 25, respectively. In this way, the coplanarity of the two supporting pins 25 may be ensured.

In the power module 100 provided in some embodiments of the present disclosure, the first insulating member 4 and the second insulating member 5 are both made of resin. For example, a material of the first insulating member 4 and/or the second insulating member 5 may include epoxy resin and silicon dioxide. The epoxy resin and silicon dioxide have high strength and rigidity after curing, and the cost is low. For example, the material of the first insulating member 4 and/or the second insulating member 5 may be the same as that of the packaging body 50.

It may be understood that when the main structure of the power module 100 is packaged, the used mold may have a structure corresponding to the first insulating member 4 and/or the second insulating member 5, so that the packaging body 50 and the first insulating member 4 and/or the second insulating member 5 are formed simultaneously when the resin is injected into the mold.

In some embodiments, as shown in FIG. 8, the plurality of control pins 21 include at least one first potential control pin group 23 and at least one second potential control pin group 24, and the first potential control pin group 23 and the second potential control pin group 24 are arranged at an interval in the length direction Y2 of the packaging body 50. The first potential control pin group 23 includes a plurality of first potential control pins 231, and the second potential control pin group 24 includes a plurality of second potential control pins 241.

For example, the potential of the first potential control pin 231 is less than the potential of the second potential control pin 241. That is to say, the first potential control pin 231 may be referred to as a low potential control pin, and a low voltage may be provided to the power module 100 through the pin; the second potential control pin 241 may be referred to as a high potential control pin, and a high voltage may be provided to the power module 100 through the pin.

A first insulating member 4 is connected between two adjacent first potential control pins 231 in a same first potential control pin group 23; and/or, a first insulating member 4 is connected between two adjacent second potential control pins 241 in a same second potential control pin group 24.

For example, in the power module 100 in FIG. 8, the plurality of control pins 21 include one low potential control pin group 23 and three high potential control pin groups 24, and the low potential control pin group 23 is located on a side of the second side 50B of the packaging body 50 in the length direction Y2 of the packaging body, and the three high potential control pin groups 24 are located on another side of the second side 50B of the packaging body 50 in the length direction Y2 of the packaging body.

The low potential control pin group 23 may include thirteen low potential control pins 231. In the thirteen low potential control pins 231, seven low potential control pins 231 are first control pins 211, and the remaining six low potential control pins 231 are second control pins 212. The seven first control pins 211 and the six second control pins 212 are arranged evenly and alternately in the length direction Y2 of the packaging body 50, and a first insulating member 4 is connected between the adjacent first control pin 211 and second control pin 212.

Each high potential control pin group 24 includes two high potential control pins 241, and the two high potential control pins 241 are a first control pin 211 and a second control pin 212, respectively. In this case, a first insulating member 4 is connected between the two high potential control pins 241 in the high potential control pin group 24.

In this way, the first insulating member 4 may be connected between two adjacent low potential control pins 231 that are proximate to each other and the first insulating member 4 may be connected between two adjacent high potential control pins 241 that are proximate to each other. The first insulating member 4 may effectively support two adjacent control pins 21, so as to prevent the control pins 21 from being deformed.

In some examples, as shown in FIG. 8, a minimum distance between the low potential control pin group 23 and the high potential control pin group 24 may be greater than a distance between two adjacent low potential control pins 231 in a same low potential control pin group 23, and/or, the minimum distance between the low potential control pin group 23 and the high potential control pin group 24 is greater than a minimum distance between two adjacent high potential control pins 241 in a same high potential control pin group 24. In this case, the first insulating member 4 may not be connected between the low potential control pin group 23 and the high potential control pin group 24. That is to say, there is a large insulation distance between the low potential control pin group 23 and the high potential control pin group 24. As a result, even if the low potential control pin 231 or the high potential control pin 241 is deformed, the two may not be electrically connected with each other either. In this case, there is no need to provide the first insulating member 4 between the low potential control pin group 23 and the high potential control pin group 24.

In some examples, there are a plurality of high potential control pin groups 24, and a minimum distance between two adjacent high potential control pin groups 24 is greater than the minimum distance between two adjacent high potential control pins 241 in a same high potential control pin group 24. That is to say, there is a large insulation distance between two adjacent high potential control pins 241. In this case, there is no need to provide the first insulating member 4 between two adjacent high potential control pins 241.

In some embodiments, as shown in FIG. 8, at least one isolation portion 51 may be disposed on the second side 50B of the packaging body 50. For example, an isolation portion 51 may be disposed between the adjacent first potential control pin group 23 and second potential control pin group 24, so as to increase the insulation distance between the first potential control pin group 23 and the second potential control pin group 24. For another example, an isolation portion 51 may also be disposed between two adjacent second potential control pin groups 24, so as to increase the insulation distance between the two adjacent second potential control pin groups 24.

For example, the isolation portion 51 may be a protrusion formed by the second side 50B of the packaging body 50 protruding in a direction away from the center of the packaging body 50. Alternatively, the isolation portion 51 may be a concave portion formed by the second side 50B of the packaging body 50 being recessed toward the center of the packaging body 50.

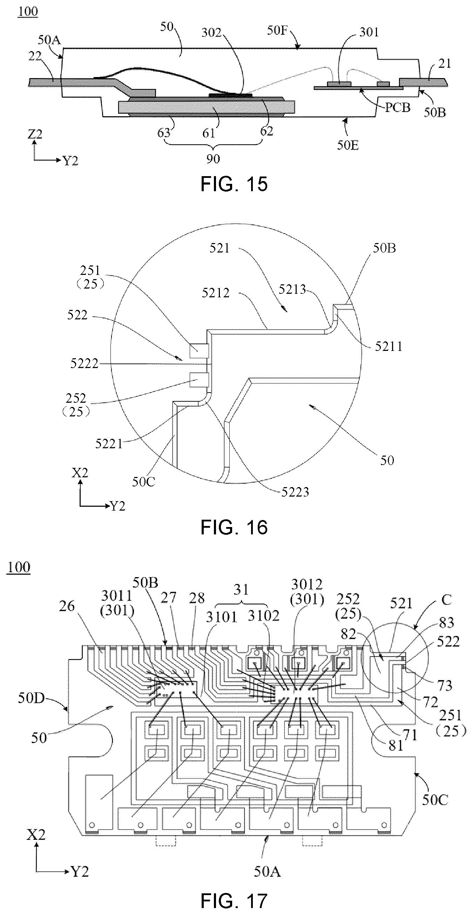

In the power module 100 provided in some embodiments of the present disclosure, as shown in FIG. 16, in a case where the plurality of pins 20 further include two supporting pins 25 (e.g., a first supporting pin 251 and a second supporting pin 252) led out from the third side 50C of the packaging body and arranged at an interval, as shown in FIG. 17, the plurality of control pins 21 include a first functional pin 26 and a second functional pin 27. In the length direction Y2 of the packaging body 50, the second functional pin 27 is proximate to a middle portion of the second side 50B of the packaging body 50, and the first functional pin 26 is located on a side of the second functional pin 27 away from the two supporting pins 25.

That is to say, the first functional pin 26, the second functional pin 27 and the supporting pins 25 are substantially arranged evenly in the length direction Y2 of the packaging body 50 in sequence, and are led out from different sides of the packaging body 50. In this way, the entire power module 100 may be supported from different sides of the power module 100, so that the shaking problem caused by supporting the power module 100 from a single side of the power module 100 may be avoided, the stability of the power module 100 may be improved and the power module 100 may be prevented from being deformed.

Moreover, the supporting pins 25 are led out from the third side 50C of the packaging body 50, which may avoid increasing the space of the power module 100 in the length direction Y2 that is occupied by the supporting pins 25 and avoid wasting materials. As a result, it is possible to make the arrangement of the pins used to support the power module 100 reasonable and compact, so that the volume of the power module 100 may be reduced and the miniaturization of the power module 100 may be improved.

In addition, the first functional pin 26 and the second functional pin 27 are led out from the second side 50B of the packaging body 50, and the supporting pins 25 are led out from the third side 50C of the packaging body 50, which may also increase the insulation distance between these pins, thereby improving the safety performance of the power module 100.

In some embodiments, as shown in FIG. 17, the first functional pin 26, the second functional pin 27, and the first supporting pin 251 are connected to the driving substrate 31. For example, the first functional pin 26, the second functional pin 27, and the first supporting pin 251 are connected with the driving substrate 31 to form a one-piece structure. The first functional pin 26 and the second functional pin 27 are led out from the second side 50B of the packaging body 50 and both electrically connected to the peripheral circuit. The first supporting pin 251 is led out from the third side 50C of the packaging body 50, so as to support the power module 100 from a side different from the side from which the control pins 21 are led out, thereby ensuring the installation reliability of the power module 100.

In some embodiments, as shown in FIG. 17, the power module 100 includes a plurality of driving chips 301. For example, the power module 100 includes a first driving chip 3011 and a second driving chip 3012. According to different uses of the power module 100, the first driving chip 3011 may be used as a low voltage driving chip, and the second driving chip 3012 may be used as a high voltage driving chip, which may improve the operating performance of the power module 100.

In this case, the driving substrate 31 may include a first driving substrate 3101 and a second driving substrate 3102 that may be formed into a one-piece structure. In the length direction Y2 of the packaging body 50, the first driving substrate 3101 and the second driving substrate 3102 are connected in sequence. The first driving chip 3011 is mounted on the first driving substrate 3101, and the second driving chip 3012 is mounted on the second driving substrate 3102, so that the structural compactness of the power module 100 may be improved.

In some examples, the first functional pin 26 is electrically connected to the first driving chip 3011 and may be used to provide a ground voltage to the first driving chip 3011. The first functional pin 26 is disposed on a side of the first driving substrate 3101 in the length direction of the power module, the first supporting pin 251 is disposed on a side of the second driving substrate 3102 away from the first driving substrate 3101 in the length direction of the power module, and the second functional pin 27 may be disposed proximate to, for example, the middle position between the first driving substrate 3101 and the second driving substrate 3102. In this way, the first functional pin 26, the second functional pin 27 and the first supporting pin 251 may be distributed evenly in the packaging body 50, so that the supporting forces of the first functional pin 26, the second functional pin 27 and the first supporting pin 251 on the power module 100 may be distributed evenly, thereby improving the reliability and stability of the power module 100.

According to these embodiments, it may be understood that the first potential control pins 231 in the first potential control pin group 23 in some embodiments described above may be used as the first functional pin 26 and the second functional pin 27 herein.

In some embodiments, as shown in FIG. 17, the plurality of control pins 21 further include a third functional pin 28, and the third functional pin 28 is electrically connected to the second driving chip 3012. The third functional pin 28 is connected to the second supporting pin 252. For example, the third functional pin 28 is connected with the second supporting pin 252 to form a one-piece structure. Moreover, in the length direction Y2 of the packaging body, the third functional pin 28 is located on a side of the second functional pin 27 away from the first functional pin 26 and proximate to the middle portion of the second side 50B of the packaging body 50. For example, the third functional pin 28 is disposed proximate to the middle position between the first driving substrate 3101 and the second driving substrate 3102.

In this way, the third functional pin 28 and the second supporting pin 252 may also support the power module 100 from two directions, so as to assist the first functional pin 26, the second functional pin 27 and the first supporting pin 251 in supporting the power module 100, so that the stability of the power module 100 may be further improved.

In the power module 100 provided in some embodiments of the present disclosure, the packaging body 50 further includes a flow guide portion 52 located at a corner of an end portion of the second side 50B in the length direction Y2 of the packaging body 50. The flow guide portion 52 is configured to achieve a function of guiding the resin to flow when the main structure of the power module 100 is packaged, so as to avoid gaps of the packaging body 50 at the corner.

In some examples, the flow guide portion 52 includes two continuous concave portions, namely, a first concave portion 521 and a second concave portion 522. The entire first concave portion 521 extends in the length direction Y2 of the packaging body 50, and the entire second concave portion 522 extends in the width direction X2 of the packaging body 50. In this way, the production process of the packaging body 50 may be simplified and the production difficulty of the packaging body 50 may be reduced.

It may be seen that the second concave portion 522 is farther away from the control pins 21 than the first concave portion 521. Therefore, the two supporting pins 25 are led out from a side of the second concave portion 522 extending in the width direction X2 of the packaging body 50, which may not only improve the miniaturization of the power module, but also extend the insulation length between these pins.

In addition, for example, as shown in FIG. 16, the lengths of the two supporting pins 25 led out of the packaging body 50 do not exceed a depth of the second concave portion 522. That is to say, in the length direction Y2 of the packaging body 50, end portions of the supporting pins 25 led out of the packaging body 50 do not exceed the third side 50C of the packaging body 50. This may not only increases a creepage distance between the supporting pin 25 and its corresponding functional pins, but also avoid the electrical contact incidents or damage to the supporting pins 25 caused by the contact between the exposed supporting pin 25 and the device located outside of the packaging body 50.

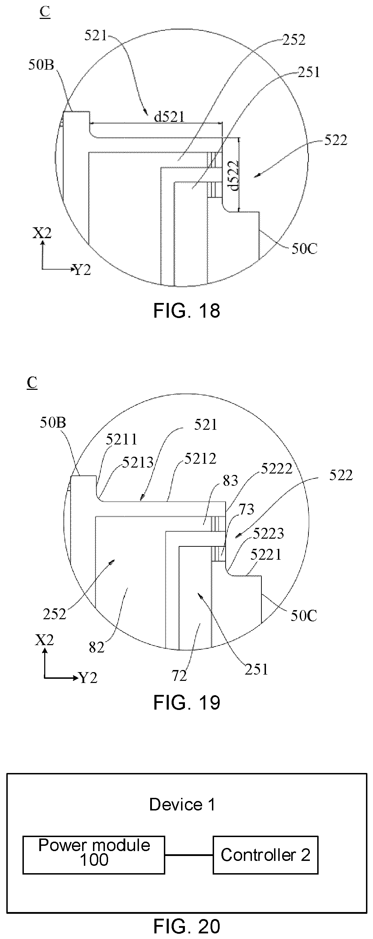

In some examples, as shown in FIG. 18, the first concave portion 521 and the second concave portion 522 each are in a shape of a long strip, and a length d521 of the first concave portion 521 is greater than or equal to a length d522 of the second concave portion 522. In this way, the shape design of the first concave portion 521 and the second concave portion 522 may be simplified, which may be conducive to molding the first concave portion 521 and the second concave portion 522, so that the production difficulty of the packaging body 50 may be further reduced.

Moreover, the lengths of the first concave portion 521 and the second concave portion 522 may be matched with the lengths of the second side 50B and the third side 50C where the first concave portion 521 and the second concave portion 522 are correspondingly located, respectively. As a result, the structure of the packaging body 50 may be stable and reliable in the premise of saving the resin material required for packaging and improving the compactness of the structure.

In the power module 100 provided in some embodiments of the present disclosure, as shown in FIGS. 16 and 19, the first concave portion 521 includes a first sub-side 5211 extending in the width direction X2 of the packaging body 50 and a second sub-side 5212 extending in the length direction Y2 of the packaging body 50. The first sub-side 5211 is connected (e.g., may be vertically connected) between the second sub-side 5212 and the second side 50B of the packaging body.

The second concave portion 522 includes a third sub-side 5221 extending in the length direction Y2 of the packaging body 50 and a fourth sub-side 5222 extending in the width direction X2 of the packaging body 50. The third sub-side 5221 is connected (e.g., may be vertically connected) between the fourth sub-side 5222 and the third side 50C of the packaging body.

In this way, the structures of the first concave portion 521 and the second concave portion 522 may be simplified, so as to achieve the long strip structures of the first concave portion 521 and the second concave portion 522, and reduce the production difficulty of the flow guide portion 52.

For example, as shown in FIGS. 16 and 19, the first concave portion 521 is further provided with a first transition arc surface 5213 between the first sub-side 5211 and the second sub-side 5212. In this way, the stress at the connection between the first sub-side 5211 and the second sub-side 5212 of the first concave portion 521 may be distributed evenly, which prevents the first concave portion from breaking due to stress concentration, so that the fatigue safety coefficient of the packaging body 50 at the first concave portion 521 may be improved.

Similar to the first concave portion 521, the second concave portion 522 may further be provided with a second transition arc surface 5223 between the third sub-side 5221 and the fourth sub-side 5222.

In some embodiments, the first supporting pin 251 and the second supporting pin 252 each may include a first pin segment, a second pin segment, and a third pin segment that are connected in sequence.

As shown in FIG. 17, the first supporting pin 251 may include a first pin segment 71, a second pin segment 72 and a third pin segment 73 connected in sequence. The first pin segment 71 and the third pin segment 73 extend in the length direction Y2 of the packaging body 50. The second pin segment 72 extends in the width direction X2 of the packaging body 50. An end portion of the third pin segment 73 away from the second pin segment 72 is led out from the third side 50C (e.g., the fourth sub-side 5222 of the second concave portion 522) of the packaging body 50.

Similar to the first supporting pin 251, the second supporting pin 252 may further include a first pin segment 81, a second pin segment 82 and a third pin segment 83 that are connected in sequence.

For example, a width of the second pin segment 82 of the second supporting pin 252 is greater than a width of the second pin segment 72 of the first supporting pin 251 (i.e., dimensions in the length direction Y2 of the packaging body 50).

In this way, the available space on the driving substrate 31 may be fully utilized to enhance the structural stability of the first supporting pin 251 and the second supporting pin 252, so that the stability of the two supporting pins in supporting the power module 100 may be improved.

In the power module 100 provided in the embodiments of the present disclosure, the main structure of the power module may adopt various layouts, which are not specifically limited herein.

For example, as shown in FIGS. 12 and 13, the control pin 21 may include a first portion located in the packaging body 50 and a second portion led out of the packaging body 50, and the first portion and the second portion are connected with each other. The driving chip 301 may be soldered on the first portion of the control pin 21 located in the packaging body 50. The power pin 22 further includes a first portion located in the packaging body 50 and a second portion led out of the packaging body 50, and the first portion and the second portion are connected with each other. The power chip 302 may be soldered on the first portion of the power pin 22 located in the packaging body 50. In addition, the power chip 302 may also be electrically connected to the driving chip 301 by wires.

For another example, as shown in FIG. 13, the connecting manner of the control pin 21, the driving chip 301, the power pin 22 and the power chip 302 is the same as that of the power module 100 in FIG. 12, and details will not be repeated herein. On this basis, as shown in FIG. 13, a side of the first portion of the power pin 22 located in the packaging body 50 away from the power chip 302 may be connected to a heat dissipation substrate 64 through an insulating layer 65 (e.g., an insulating resin sheet), and a side of the heat dissipation substrate 64 away from the first portion of the power pin 22 located in the packaging body 50 is flush with a bottom surface 50E of the packaging body 50 and exposed outside the packaging body 50. By providing the insulating layer 65 between the first portion of the power pin 22 located in the packaging body 50 and the heat dissipation substrate 64, it is possible to separate the first portion of the power pin 22 located in the packaging body 50 from the heat dissipation substrate 64, so as to prevent the first portion of the power pin 22 located in the packaging body 50 from being electrically connected to the heat dissipation substrate 64. When the power chip 302 generates heat during operation, the heat may be transferred to the heat dissipation substrate 64 through the first portion of the power pin 22 located in the packaging body 50 and the insulating layer 65. The heat dissipation substrate 64 performs heat exchange with the outside, so as to achieve heat dissipation of the power module 100. For example, the heat dissipation substrate 64 may be a copper sheet, which is not limited thereto.

For another example, as shown in FIG. 14, the power module 100 further includes a direct bond copper (DBC) ceramic substrate 90 disposed in the packaging body 50. The power chip 302 and the first portion of the power pin 22 located in the packaging body 50 are both disposed on the DBC ceramic substrate 90, and the power chip 302 is electrically connected to the power pin 22 through wires. The driving chip 301 is disposed on the first portion of the control pin 21 located in the packaging body 50, and the driving chip 301 is further electrically connected to the power chip 302 through wires. The DBC ceramic substrate 90 includes a ceramic layer 61 and a first copper layer 62 and a second copper layer 63 located on two sides of the ceramic layer 61. The power chip 302 and the first portion of the power pin 22 located in the packaging body 50 are both located on the first copper layer 62, and a side of the second copper layer 63 away from the power chip 302 is flush with the bottom surface 50E of the packaging body 50 and exposed outside the packaging body 50. When the power chip 302 generates heat during operation, the heat may be transferred to the second copper layer 63 through the first copper layer 62 and the ceramic layer 61. The second copper layer 63 performs heat exchange with the outside, so as to achieve heat dissipation of the power module 100. The control pin 21 may include a first portion located in the packaging body 50 and a second portion led out of the packaging body 50, and the first portion and the second portion are connected with each other. The driving chip 301 may be disposed, for example, soldered, on the first portion of the control pin 21 located in the packaging body 50.

For another example, as shown in FIG. 15, similar to the power module 100 in FIG. 14, the power module 100 further includes a DBC ceramic substrate 90. For the arrangement of the DBC ceramic substrate 90, the power chip 302, and the power pin 22, reference may be made to the examples described above, and details will not be repeated herein. On this basis, the power module 100 further includes a printed circuit board PCB disposed in the packaging body 50, the first portion of the control pin 21 located in the packaging body is electrically connected to the printed circuit board PCB, and the driving chip 301 is disposed on the printed circuit board PCB.

A device is further provided in some embodiments of the present disclosure, and the power module 100 provided in the embodiments described above may be applied to the device.

As shown in FIG. 20, the device 1 includes a controller 2 and at least one power module 100 provided in any one of the embodiments described above, and the power module 100 is connected to the controller 2.

The device 1 provided in the embodiments of the present disclosure may include but is not limited to an inverter or a rectifier. For example, the device 1 may be a motor drive controller.

For example, the controller 2 may generate a control signal according to a user instruction and send the control signal to the power module 100. The power module 100 generates a driving signal according to the control signal and outputs the driving signal to the corresponding driving component, so as to achieve driving control or inversion or rectification conversion.

By adopting the power module 100 of the embodiments described above, the insulation withstand voltage and insulation reliability of the device 1 provided in the embodiments of the present disclosure are improved, and the electrical safety of the device is improved.

A person skilled in the art will understand that the scope of disclosure in the present disclosure is not limited to the specific embodiments described above, and may modify and substitute some elements of the embodiments without departing from the concept of present disclosure. The scope of the present disclosure is limited by the appended claims.

## Claims

1. A frame assembly, comprising:
a frame including a first frame side and a third frame side that are disposed opposite to each other, and a second frame side connected between the first frame side and the third frame side;
a plurality of pins located in the frame, an end of a portion of the plurality of pins being connected to the first frame side, and an end of another portion of the plurality of pins being connected to the third frame side;
at least one substrate located in the frame, another end of at least one of the plurality of pins connected to a same frame side being connected to the substrate;
at least one first connecting rod located in the frame, the first connecting rod being connected between two adjacent pins of the plurality of pins connected to a same frame side; and
at least one second connecting rod located in the frame, the second connecting rod being connected between the second frame side and the plurality of pins connected to a same frame side; wherein
the first connecting rod and the second connecting rod corresponding to the plurality of pins connected to a same frame side are disposed in a staggered manner in an extending direction of the second frame side; and in the extending direction of the second frame side, the second connecting rod is closer to the substrate corresponding to the plurality of pins connected to a same frame side than the first connecting rod.

2. The frame assembly according to claim 1, wherein the plurality of pins connected to a same frame side are arranged at intervals in an extending direction of the frame side, and the second connecting rod is connected between a pin closest to the second frame side in the plurality of pins and the second frame side.

3. The frame assembly according to claim 2, wherein the frame assembly comprises a plurality of substrates and a plurality of second connecting rods; the plurality of substrates include a driving substrate and a power substrate, and the driving substrate and the power substrate are arranged at an interval in the extending direction of the second frame side; wherein
at least one of the plurality of pins connected to the first frame side is connected to the driving substrate, and a second connecting rod is connected between the pin closest to the second frame side in the plurality of pins connected to the first frame side and the second frame side; and
at least one of the plurality of pins connected to the third frame side is connected to the power substrate, and another second connecting rod is connected between the pin closest to the second frame side in the plurality of pins connected to the third frame side and the second frame side.

4. The frame assembly according to any one of claims 1 to 3, wherein the frame assembly comprises a plurality of second connecting rods, and the frame further includes a fourth frame side disposed opposite to the second frame side and connected between the first frame side and the third frame side; wherein
the plurality of pins connected to a same frame side are arranged at intervals in an extending direction of the frame side, and a second connecting rod is connected between a pin closest to the second frame side in the plurality of pins and the second frame side, and a second connecting rod is also connected between a pin closest to the fourth frame side in the plurality of pins and the fourth frame side.

5. The frame assembly according to any one of claims 1 to 4, further comprising:
a packaging body for packaging the at least one substrate; wherein
the pin includes a first portion located in the packaging body and a second portion led out of the packaging body; and
for the pin connected to the second connecting rod, the second connecting rod is connected to the second portion of the pin.

6. The frame assembly according to claim 5, wherein the second portion includes a first sub-segment and a second sub-segment, the first sub-segment is connected between the first portion and the second sub-segment, the second sub-segment is capable of being bent with respect to the first sub-segment, and the second connecting rod is connected to the first sub-segment.

7. The frame assembly according to claim 6, wherein in the extending direction of the second frame side, a minimum distance from a connection between the second connecting rod and the first sub-segment to the packaging body is greater than a thickness of the frame; and/or
a minimum distance from the connection between the second connecting rod and the first sub-segment to the second sub-segment is greater than the thickness of the frame.

8. The frame assembly according to claim 6 or 7, wherein in the extending direction of the second frame side, a length of the first sub-segment is greater than a width of the second connecting rod.

9. The frame assembly according to any one of claims 6 to 8, wherein an extending direction of the second connecting rod is perpendicular to an extending direction of the first sub-segment.

10. A power module, comprising:
a packaging body;
a plurality of chips located in the packaging body, the plurality of chips including at least one driving chip and at least one power chip; wherein the at least one driving chip and the at least one power chip are arranged at an interval in a width direction of the packaging body;
a plurality of pins including a plurality of control pins led out from a second side of the packaging body and a plurality of power pins led out from a first side of the packaging body, the first side and the second side both extending in a length direction of the packaging body and being disposed opposite to each other; wherein the plurality of control pins are arranged at intervals in the length direction of the packaging body and electrically connected to the at least one driving chip, and the plurality of power pins are arranged at intervals in the length direction of the packaging body and electrically connected to the at least one power chip; and
at least one first insulating member located outside the packaging body, a first insulating member being connected between two adjacent control pins.

11. The power module according to claim 10, wherein the first insulating member is connected to a portion of the packaging body located between the two adjacent control pins.

12. The power module according to claim 10 or 11, wherein in the width direction of the packaging body, a length of the first insulating member is less than a length of at least one of the two adjacent control pins.

13. The power module according to any one of claims 10 to 12, wherein the first insulating member is connected between opposite sides of the two adjacent control pins; or
the first insulating member is connected between the opposite sides of the two adjacent control pins, and the first insulating member is flush with the two adjacent control pins in a thickness direction of the packaging body.

14. The power module according to any one of claims 10 to 13, wherein a cutting portion is disposed at an end of the first insulating member away from the packaging body; in the length direction of the packaging body, a width of the cutting portion is less than a width of the first insulating member.

15. The power module according to claim 14, wherein the cutting portion is a through groove and penetrates through two surfaces of the first insulating member in a thickness direction of the packaging body.

16. The power module according to any one of claims 10 to 15, wherein the plurality of pins further include two supporting pins led out from a third side of the packaging body and arranged at an interval; the power module further comprises:
a second insulating member located outside the packaging body, the second insulating member being connected between the two supporting pins.

17. The power module according to claim 16, wherein the second insulating member is connected to a portion of the packaging body located between the two supporting pins.

18. The power module according to any one of claims 10 to 17, wherein the power module comprises a plurality of first insulating members; wherein
the plurality of control pins include a first potential control pin group and a second potential control pin group, and a first insulating member is connected between two adjacent control pins in a same first potential control pin group; and/or
a first insulating member is connected between two adjacent control pins in a same second potential control pin group.

19. The power module according to any one of claims 16 to 18, wherein the plurality of control pins include a first functional pin and a second functional pin; in the length direction of the packaging body, the second functional pin is located between the first functional pin and two supporting pins; the first functional pin, the second functional pin and the two supporting pins are configured to support the power module from different sides of the power module.

20. The power module according to claim 19, wherein the packaging body includes a flow guide portion located at a corner where the second side is connected with a third side, and the two supporting pins are led out from the flow guide portion.

21. A device comprising a controller and the power module according to any one of claims 10 to 20, wherein the power module is connected to the controller.
